Europäisches Patentamt

European Patent Office

Office européen des brevets

(11) Publication number: **0 098 513**
**B1**

(12) **EUROPEAN PATENT SPECIFICATION**

(45) Date of publication of patent specification: **05.03.86**

(21) Application number: **83106316.9**

(22) Date of filing: **29.06.83**

(51) Int. Cl.⁴: **H 02 M 9/00, H 01 S 3/097**

(54) **Voltage control circuit.**

(30) Priority: **01.07.82 US 394227**

(43) Date of publication of application:
**18.01.84 Bulletin 84/03**

(45) Publication of the grant of the patent:
**05.03.86 Bulletin 86/10**

(84) Designated Contracting States:
**DE FR GB IT**

(56) References cited:
**DE-C-1 116 316**
**FR-A-1 580 879**

**Soviet Inventions Illustrated, week D17, 3 June
1981 Section U24.
IEEE JOURNAL OF QUANTUM ELECTRONICS,
vol. QE-9, no. 2, February 1973 M.C.
RICHARDSON et al.: "A 300-J multimegawatt
CO2 laser", pages 236-243.**

(73) Proprietor: **HONEYWELL INC.**
**Honeywell Plaza**
**Minneapolis Minnesota 55408 (US)**

(72) Inventor: **Matthys, Robert J.**
**2901 W. Armour Terrace**
**Minneapolis Minnesota 55418 (US)**

(74) Representative: **Herzbach, Dieter et al**
**Honeywell Europe S.A. Holding KG Patent- und
Lizenzabteilung Kaiserleistrasse 55 Postfach 184
D-6050 Offenbach am Main (DE)**

## Description

This invention relates to a voltage control circuit according to the preamble of claims 1 or 2. Particularly disclosed herein are voltage doubler circuits for use with gas lasers and, more particularly, for use with transversely excited atmospheric pressure (TEA) lasers.

Many voltage control circuits, including voltage doublers, have been disclosed in the past (see for instance "Soviet Inventions Illustrated Week" D17, June 3, 1981, Section U24). Such circuits have been designed to use either DC or AC power supplies and, in the AC supply case, charge energy storage elements (e.g. capacitors) during only one-half cycle or the full cycle.

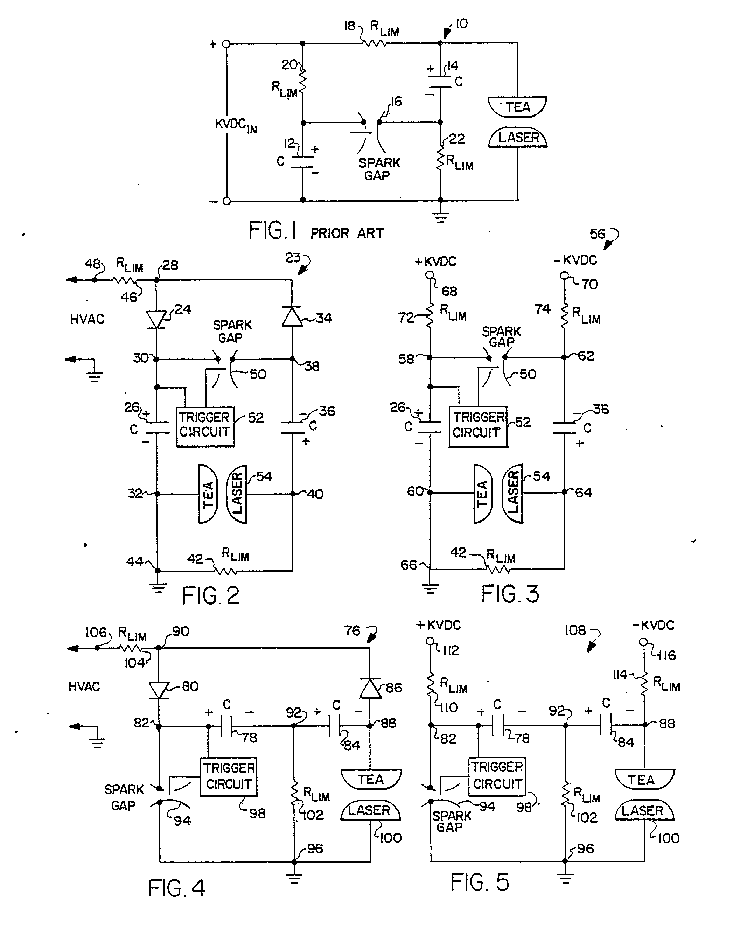

A popular prior art voltage doubler for gas lasers is shown in Figure 1, i.e. the Marx generator. In Marx generator 10 the DC supply KVDC$_{IN}$ charges capacitors 12 and 14 (which have the same capacitance), with the same polarity, as shown. After capacitors 12 and 14 are fully charged, when spark gap 16 fires, capacitors 12 and 14 are momentarily placed in series thus applying the full voltage stored in capacitors 12 and 14 to the load, a TEA laser. Since two capacitors 12 and 14 are provided, twice the voltage which can be stored on either capacitor is applied to the TEA laser.

However, prior to firing spark gap 16, when capacitor 14 is fully charged, the full input voltage KVDC$_{IN}$ which is equal to one-half of device 10's output voltage is applied to the TEA laser. Generally the maximum output voltage of device 10 is just sufficient to discharge the TEA laser. In that case, one-half the output voltage is approximately one-half the laser discharge voltage. Application of one-half the laser discharge voltage to the TEA laser prior to the selected firing of the laser leads to undesirable corona and gas discharge effects inside the laser. Spark gap 16 must withstand one-half the full laser discharge voltage in Marx generator 10 for proper operation.

Furthermore, from "IEEE Journal of Quantum Electronics", Vol. QE-9, No. 2, February 1973, in particular Fig. 2 on page 238, a modified Marx generator is known, which uses a plurality of spark gaps to achieve some preionization before the onset of the main discharge.

Basically, any Marx generator multiplies an output voltage and its spark gap must withstand half the output voltage, but it supplies one-half the full DC output voltage to the laser prior to pulsing the laser with the full output voltage. Further, in the Marx generator, no ground connection is made directly to the spark gap. Such a connection is desirable in high voltage applications.

It is, therefore, the object of the present invention to provide a simple voltage control circuit being capable of supplying substantial DC voltage to a load only when switched and being capable of being grounded not only with respect to the load but also with respect to the switching means. This object is achieved by the characterizing features of independent claims 1 and 2. Further advantageous embodiments of the voltage control circuit according to the invention may be taken from the dependent sub-claims.

Summary of the invention

An electrical circuit is provided which includes a first energy storage means adapted to store electrical energy in response to a potential source of a first polarity relative to a reference point in said circuit, thereby providing a first voltage of a first magnitude, a second energy storage means adapted to store electrical energy, without affecting said first energy storage means, in response to a potential source of a second polarity relative to said reference point, thereby providing a second voltage of a second magnitude, and means for electrically connecting said first and second energy storage means so as to provide an output voltage related to the sum of said first and second magnitudes.

The above described circuit can be adapted to supply substantial DC voltage to a load only upon electrically connecting said electrical energy storage means in series by connecting said electrical connections means (opened) between the positive charging pole of said first electrical energy storage means and the negative charging pole of said second electrical energy storage means, connecting said load between the negative charging pole of said first electrical energy storage means and the positive charging pole of said second electrical energy storage means and charging said first and second energy storage means in parallel. When said electrical connection means is closed, said first and second energy storage means will be connected in series with the same polarity and apply a voltage related to the sum of said corresponding first and second voltages to said load. First and second embodiments of the above circuit are disclosed, one which utilizes an AC source and the other which utilizes a DC source.

Third and fourth embodiments are provided which do apply substantial voltage to a load prior to electrically connecting first and second electrical energy storage means in series, but provide a common ground or reference point between a means for connecting said storage means in series and a load. This is particularly desirable in high voltage, voltage multiplier circuit applications.

Brief description of the drawings

Figure 1 is an electrical schematic of a prior art circuit.

Figure 2 is an electrical schematic of the first embodiment of the present invention.

Figure 3 is an electrical schematic of the second embodiment of the present invention.

Figure 4 is an electrical schematic of the third embodiment of the present invention.

Figure 5 is an electrical schematic of the fourth embodiment of the present invention.

## Description of the preferred embodiments

The first embodiment (circuit 23) in Figure 2 includes diode 24 (i.e. a first unidirectional current conducting means) connected in series with capacitor 26 (i.e. a first capacitor means, a capacitor means along or in conjunction with a diode comprise a means for storing electrical energy). Note that "connected" will mean "electrically connected" unless otherwise indicated. Diode 24 is connected between nodes 28 and 30 (i.e. first and second terminating regions) and capacitor 26 is connected between node 30 and node 32 (i.e. a third terminating region).

Similarly, diode 34 (i.e. a second unidirectional current conducting means) is electrically connected in series with capacitor 36 (i.e. a second capacitor means). Diode 34 is connected between node 28 and node 38 (i.e. a fourth terminating region). Capacitor 36 is connected between node 38 and node 40 (i.e. a fifth terminating region).

Current limiting resistor 42 (i.e. a first resistance means) is connected between node 40 and node 44. Node 44 is depicted as ground in Figure 2, however, if an AC source is electrically connected between being nodes 28 and 44, node 44 will alternate between being an input node and a reference node during each cycle. Current limiting resistor 46 is connected between node 28 and node 48. Again, node 48 serves as an input node or a reference node if an AC source is connected thereto.

Spark gap 50 (i.e. means for electrically connecting capacitors 26 and 36) is connected between nodes 30 and 38. Spark gap 50 can be of various configurations depending on the intended use of circuit 23. If circuit 23 will be employed to produce an output voltage for a gas laser, circuit 23 will likely be designed as a voltage doubler. Spark gap 50, however, must withstand the full voltage output of circuit 23 when spark gap 50 is open. A trigger circuit 52 is employed to trigger the firing of spark gap 50 at selected times. Trigger circuit 52 often includes a step up transformer, is capacitively isolated from high voltage DC sources and incorporates a bleeder resistor between a charging line and an electrode of the spark gap to reduce the chances of unwanted firing of the spark gap. Spark gaps are preferable to semiconductor switches when circuit 23 is used with gas lasers because the production of laser discharge voltages requires high voltages (e.g. 25K to 125K volts) as well as fast switching. The voltages required for gas lasers are roughly an order of magnitude higher than semiconductor switches can handle.

TEA laser 54 is a load to which the output of circuit 23 is applied. TEA laser 54 is connected between nodes 32 and 40. TEA lasers are designed to deliver high peak power outputs. The ability to pulse such lasers with the laser discharge voltage when desired and to not apply a voltage to the laser electrodes during non-fire times are desirable characteristics of a gas laser discharge voltage circuit. If during non-fire times as much as one-half the full laser discharge voltage is applied across gas laser, undesirable corona effects and ionization can occur. These undesirable effects can degrade the gas, shorten the useful life of the gas, and even cause the ionization to spread through the gas and lead to an actual laser discharge.

In operation, circuit 23 is supplied by a high voltage AC source (HVAC) applied between nodes 44 and 48. During positive half cycles (i.e. node 48 is the plus terminal), diode 24 passes current from node 44 to node 48 charging capacitor 26, with the polarity shown. Diode 34 allows only negligible, reverse bias current to flow to capacitor 36 during positive half cycles. During negative half cycles (i.e. node 44 is the plus terminal) diode 34 passes current from node 48 to node 44 charging capacitor 36 with the polarity shown. Diode 24 allows only negligible reverse bias current to flow to capacitor 26 during negative half cycles.

Each side or branch of circuit 23 (i.e. a first branch between nodes 28 and 44 including diode 24 and capacitor 26, and a second branch between nodes 28 and 44 including diode 34 and capacitor 36) charges as a separate RC network. A typical value of capacitance for capacitors 26 and 36 is 0.15 μF and of resistance for resistors 42 and 46 is 10K ohms. (Note that in describing circuit 23 in terms of branches, nodes 30, 38, 28 and 44 could be described as first, second, third and fourth common nodes, respectively and nodes 32 and 40 could be described as first and second terminating regions, respectively).

After a few time constants then, capacitors 26 and 36 will be fully charged. Furthermore, during the charging of capacitors 26 and 36, only a small, transient current will appear in resistor 42 thus producing an insubstantial voltage drop (relative to the voltage required to produce the above described undesirable effects in gas lasers) across resistor 42, and consequently across TEA laser 54. Once capacitors 26 and 36 are fully charged, no voltage drop will appear across resistor 42 (because no current will be flowing through resistor 42) and thus no voltage will be applied to TEA laser 54.

The capacitance and resistance valves of capacitors 26 and 36 and resistors 42 and 46 can be adjusted to vary the time constants of said first and second branches as well as the maximum voltage appearing across TEA laser 54 (or a load) during the charging of capacitors 26 and 36.

When capacitors 26 and 36 are fully charged, trigger circuit 52 can be activated firing (i.e. closing) spark gap 50. This in turn momentarily connects capacitors 26 and 36 in series with spark gap 50 and TEA laser 54. Thus, since the polarities of charged capacitors 26 and 36 are such that the voltages corresponding to charged capacitors 26 and 36 will add, assuming insubstantial voltage drops across spark gap 50 and in the remainder of this series connection, the output voltage applied to TEA laser 54 will equal the sum of the corresponding voltages on capacitors 26 and 36.

TEA laser 54 has been chosen to fire upon application of such an output voltage, therefore TEA laser 54 will fire only when spark gap 50 is fired.

Furthermore, since only an insubstantial voltage drop will occur across TEA laser 54 prior to the closing of spark gap 50, said undesirable corona and ionization will not occur in TEA laser 54. With only capacitors 26 and 36 in circuit 23, a voltage doubler is provided.

A variation of the first embodiment would substitute a third diode (not shown) in place of resistor 42. Said third diode would be connected to pass substantial current only in the same direction as diode 34 (i.e. the P side of a semiconductor diode would be connected to node 44). This variation would offer the advantage of a smaller transient voltage across TEA laser 54 during charging of capacitors 26 and 36.

Figure 3 shows the second circuit embodiment 56 of the present invention. Elements corresponding to elements of the first embodiment 23 have been numbered the same for clarity. As Figure 3 readily shows, the difference in the first and second embodiments lies in the means and manner of charging said first and second circuit branches.

In Figure 3, supply HVAC is replaced by a high voltage direct current supply (or supplies) for providing +KVDC and −KVDC. In circuit 56 capacitor 26 is connected between node 58 (i.e. a first terminating region) and node 60 (i.e. a second terminating region). Capacitor 36 is connected between node 62 (i.e. a third terminating region) and node 64 (i.e. a fourth terminating region). Resistor 42 is connected between node 64 and node 66 (i.e. a fifth terminating region). Trigger circuit 52 is connected relative to spark gaps 50 and capacitors 26 and 36 as it was in circuit 23.

Nodes 68 and 70 serves as input nodes for +KVDC and −KVDC respectively. Current limiting resistors 72 and 74 are connected between nodes 58 and 68, and nodes 62 and 70, respectively.

In operation, circuit 56 fully charges capacitors 26 and 36 in the separate RC branches (i.e. one branch including capacitor 26 and the other capacitor 36). The capacitance and resistance values are chosen with the same functional characteristics in mind as in circuit 23. Thus, again, no substantial voltage appears across TEA laser 54 prior to firing spark gap 50. Similarly, resistor 42 can also be replaced by a diode (not shown) adapted to only pass substantial current from node 66 to node 64. In some cases, particularly for high voltage applications, circuit 56 may be desired over circuit 23.

The third preferred circuit embodiment 76 of the present invention is shown in Figure 4. It is not an object of this particular embodiment to apply substantial voltage across the load only when a first and a second electrical energy storage means are connected in series. Instead, one-half the laser discharge voltage is applied across the laser (or load) as in the Marx generator, however, circuit 76 affords a direct connection between an electrical connecting means (e.g. a spark gap) and a ground point whereas the Marx generator circuit does not.

In Figure 4, capacitor 78 (i.e. a first capacitor means) is connected in series with diode 80 (i.e. a first unidirectional current conducting means) with node 82 (i.e. a first common terminating region) therebetween. Capacitor 84 (i.e. a second capacitor means) is connected in series with diode 86 (i.e. a second unidirectional current conducting means) with node 88 (i.e. a second common terminating region) therebetween.

Circuit 76 includes two branches, one including capacitor 78 and another including capacitor 84. These branches are connected between nodes 90 and 92 (i.e. third and fourth common terminating regions). Spark gap 94 (i.e. means for electrically connecting capacitors 78 and 84) is connected between node 82 and node 96 (i.e. an output node relative to a load). A load (e.g. a TEA laser 100) is connected between nodes 88 and 96. A trigger circuit 98 is connected to spark gap 94. Current limiting resistors 102 and 104 are connected, respectively, between nodes 92 and 96, and nodes 90 and 106.

When HVAC is applied between nodes 96 and 106 of circuit 76, capacitor 78 will charge through resistor 102 with the polarity shown during the positive half cycle (i.e. node 106 positive). During the negative half cycle, capacitor 84 will charge with the polarity shown. Once capacitors 78 and 84 are charged, trigger circuit 98 is activated, firing spark gap 94 and placing capacitors 78 and 84 in series with spark gap 94 and TEA laser 100.

Since the polarities of charged capacitors 78 and 84 will allow the voltages held across the capacitors 78 and 84 to add, the sum of the voltages corresponding to fully charged capacitors 78 and 84 will be applied to TEA laser 100 when spark gap 94 is closed. This of course assumes negligible voltage drops across spark gap 94 and in the connections to TEA laser 100. With only capacitors 78 and 84 in circuit 76, circuit 76 will serve as a voltage doubler.

A fourth and final embodiment, circuit 108, is depicted in Figure 5. The fourth embodiment substitutes a high voltage DC supply for the AC supply in the third embodiment. Corresponding elements between the third and fourth embodiments are numbered the same for clarity.

Circuit 108 substitutes separated plus and minus high voltage DC sources (i.e. +KVDC and −KVDC) for HVAC in circuit 76. Current limiting resistor 110 is connected between the +KVDC input terminal 112 and node 82. Current limiting resistor 114 is connected between the −KVDC input terminal 116 and node 88. Capacitors 78 and 84 are charged by +KVDC and −KVDC, respectively, with the polarity shown. Thereafter circuit 108 operates the same as circuit 76 to apply a multiple of the input voltage as an output voltage to TEA laser 100.

Note that in both circuits 76 and 108 a common ground or reference point, i.e. node 96, is provided for TEA laser 100 and spark gap 94. In circumstances where the application of approximately one-half the full laser discharge voltage to TEA laser 100 prior to the selected firing of spark gap 94 is not a determinative limitation, circuits 76 and 108 are particularly useful. Further in both circuits 78 and 108, spark gap 94 need withstand only one-half the circuit output voltage when spark gap 94 is open.

Of course, the various circuit elements and nodes described herein are given only as examples of electrical energy storage means, capacitor means, unidirectional current conducting means, electrical connecting means and terminating regions. Equivalents known to those skilled in the art can be substituted for the particular elements or nodes described herein.

## Claims

1. Voltage control circuit comprising first energy storage means (26) and second energy storage means (36), both storage means being adapted to store electrical energy delivered from a potential source via current limiting means, thereby providing a first voltage of a first magnitude and a second voltage of a second magnitude, and further comprising switching means (50, 52) for electrically connecting said first and second energy storage means in series so as to provide an output voltage related to the sum of said first and second magnitudes to a load (54), whereat the load is connected in parallel to the series connection of both energy storage means (26, 36) and the connecting means (50), with a first terminal (32, 60) of the load being connected directly to the common reference potential, characterized in that

a) said potential source delivers a first potential (HVAC, 42; +KVDC) of a first polarity and a second potential (HVAC, 34; −KVDC) of an opposite polarity with both potentials being related to the common reference potential for separately loading said first and second energy storage means (26, 36), and the current limiting means (46; 72, 74) being arranged in the circuit between the said potential source and the common reference potential;

b) the said switching means (50) is arranged to connect those terminals of the energy storing means (26, 36) which are connected to the potential source;

c) the load (54) is connected between the terminals of the energy storing means (26, 36) which are connected to the reference potential; and

d) the second terminal (40, 64) of the load (54) is further connected to the common reference potential by means of a resistor (42) or a diode, the polarity of which is opposed to the polarity of the energy storage means.

2. Voltage control circuit comprising first energy storage means (78) and second energy storage means (84), both storage means being adapted to store electrical energy delivered from a potential source via current limiting means, thereby providing a first voltage of a first magnitude and a second voltage of a second magnitude and further comprising switching means (94, 98) for electrically connecting said first and second energy storage means in series so as to provde an output voltage related to the sum of said first and second magnitudes to a load (100), characterized in that

a) said potential source delivers a first potential (HVAC, 80; +KVDC) of a first polarity and a second potential (HVAC, 86; −KVDC) of an opposite polarity with both potentials being related to a common reference potential for separately loading said first and second energy storage means (78, 84); and

b) one terminal of the connecting means (94) together with one terminal of the load (100) is connected to the common reference potential and that the other terminals of said connecting means (94) and said load (100) are connected by the series connection of both energy storage means (78, 84) with a common circuit node (92) of both energy storage means being connected to the common reference potential by means of a resistor (102).

3. Voltage control circuit according to claim 1 or 2, characterized in that said potential source is an AC potential source (HVAC) having rectifying means (24, 80; 34, 86) connected in series to said energy storage means (26, 78; 36, 84).

4. Voltage control circuit according to claim 1 or 2, characterized in that said potential source comprises two DC voltage sources (+KVDC, −KVDC).

5. Voltage control circuit according to one of the claims 1 to 4, characterized in that said switching means is a spark gap (50; 94).

6. Voltage control circuit according to claim 3, characterized in that said rectifying means are diodes (24, 34; 80, 86).

7. Voltage control circuit according to one of the claims 1 to 4, characterized in that said energy storage means are capacitors (26, 36; 78, 84) having the same capacitance value.

## Patentansprüche

1. Spannungssteuerschaltung mit einer ersten Energiespeichereinrichtung (26) und einer zweiten Energiespeichereinrichtung (36), wobei beide Speichereinrichtungen von einer Potentialquelle über Strombegrenzungsmittel abgegebene elektrische Energie speichern können und eine erste Spannung mit einer ersten Größe und eine zweite Spannung mit einer zweiten Größe vorgeben und mit einer Schalteinrichtung (50, 52) zur elektrischen Verbindung der ersten und zweiten Energiespeichereinrichtung in Reihe, um eine Ausgangsspannung entsprechend der Summe der ersten und zweiten Größe an eine Last (54) abzugeben, wobei die Last parallel zu der Serienschaltung der beiden Energiespeichereinrichtungen (26, 36) und der Verbindungseinrichtung (50) geschaltet ist und ein erster Anschluß (32, 60) der Last direkt an das gemeinsame Bezugspotential angeschlossen ist, dadurch gekennzeichnet,

a) daß die Potentialquelle ein erstes Potential (HVAC, 24; +KVDC) mit einer ersten Polarität und ein zweites Potential (HVAC, 34; −KVDC) mit entgegengesetzter Polarität liefert, wobei beide Potentiale auf das gemeinsame Bezugspotential bezogen sind, um die erste und zweite Energiespeichereinrichtung (26, 36) getrennt zu laden und daß die Strombegrenzungsmittel (46; 72, 74) in dem Schaltkreis zwischen der Potentialquelle und dem gemeinsamen Bezugspotential angeordnet sind;

b) daß die Schalteinrichtung (50) der Verbindung jener Anschlüsse der Energiespeichereinrichtung (26, 36) dient, die an die Potentialquelle angeschlossen sind;

c) daß die Last (54) an die Anschlüsse der Energiespeichereinrichtung (26, 36) angeschlossen ist, die mit dem Bezugspotential verbunden sind; und

d) daß der zweite Anschluß (40, 64) der Last (54) ferner an das gemeinsame Bezugspotential über einen Widerstand (42) oder eine Diode angeschlossen ist, deren Polarität der Polarität der Energiespeichereinrichtungen entgegengesetzt ist.

2. Spannungssteuerschaltung mit einer ersten Energiespeichereinrichtung (78) und einer zweiten Energiespeichereinrichtung (84), wobei beide Speichereinrichtungen von einer Potentialquelle über Strombegrenzungsmittel abgegebene elektrische Energie speichern können und eine erste Spannung mit einer ersten Größe und eine zweite Spannung mit einer zweiten Größe vorgeben und mit einer Schalteinrichtung (94, 98) zur elektrischen Verbindung der ersten und zweiter Energiespeichereinrichtungen in Reihe, um eine Ausgangsspannung entsprechend der Summe der ersten und zweiten Größe an eine Last (100) abzugeben, dadurch gekennzeichnet,

a) daß die Potentialquelle ein erstes Potential (HVAC, 80; +KVDC) mit einer ersten Polarität und ein zweites Potential (HVAC, 86; −KVDC) mit entgegengesetzter Polarität liefert, wobei beide Potentiale auf das gemeinsame Bezugspotential bezogen sind, um die ersten und zweiten Energiespeichereinrichtungen (78, 84) zu laden; und

b) daß ein Anschluß der Verbindungseinrichtung (94) zusammen mit einem Anschluß der Last (100) an das gemeinsame Bezugspotential angeschlossen ist und daß die anderen Anschlüsse der Verbindungseinrichtung (94) und der Last (100) durch die Reihenschaltung beider Energiespeichereinrichtungen (78, 84) verbunden sind, wobei ein gemeinsamer Schaltungsknoten (92) beider Energiespeichereinrichtungen über einen Widerstand (102) an das gemeinsame Bezugspotential angeschlossen ist.

3. Spannungssteuerschaltung nach Anspruch 1 oder 2, dadurch gekennzeichnet, daß die Potentialquelle eine Wechselspannungspotentialquelle (HVAC) ist und daß Gleichrichtereinrichtungen (24, 80; 34, 86) in Reihe zu den Energiespeichereinrichtungen (26, 78; 36, 84) geschaltet sind.

4. Spannungssteuerschaltung nach Anspruch 1 oder 2, dadurch gekennzeichnet, daß die Potentialquelle zwei Gleichspannungsquellen (+KVDC, −KVDC) umfaßt.

5. Spannungssteurschaltung nach einem der Ansprüche 1 bis 4, dadurch gekennzeichnet, daß die Schalteinrichtung eine Zündfunkenstrecke (50; 94) ist.

6. Spannungssteuerschaltung nach Anspruch 3, dadurch gekennzeichnet, daß die Gleichrichtereinrichtungen Dioden (24, 34; 80, 86) sind.

7. Spannungssteuerschaltung nach einem der Ansprüche 1 bis 4, dadurch gekennzeichnet, daß die Energiespeichereinrichtungen Kondensatoren (26, 36, 78, 84) mit gleichem Kapazitätswert sind.

**Revendications**

1. Circuit de commande de tension comprenant un premier moyen de stockage d'énergie (26) et un second moyen de stockage d'énergie (36), ces deux moyens de stockage étant adaptés à stocker de l'énergie électrique fournie par une source de potentiel par l'intermédiaire d'un moyen de limitation de courant, fournissant ainsi une première tension d'une première amplitude et une seconde tension d'une seconde amplitude, et comprenant en outre un moyen de commutation (50, 52) pour connecter électriquement les premier et second moyens de stockage d'énergie en série, de façon à fournir une tension de sortie associée à la somme des première et seconde amplitudes vers une charge (54), tandis que la charge est connectée en parallèle à la connexion en série des deux moyens de stockage d'énergie (26, 36) et des moyens de connexion (50), une première borne (32, 60) de la charge étant connectée directement au potentiel de référence commun, caractérisé en ce que:

a) la source de potentiel fournit un premier potentiel (HVAC, 42; +KVDC) d'une première polarité et un second potentiel (HVAC, 34; −KVDC) d'une polarité opposée, les deux potentiels étant associés à un potentiel de référence commun, pour charger séparément les premier et second moyens de stockage d'énergie (26, 36) et les moyens de limitation de courant (46; 72, 74) étant disposés dans le circuit entre ladite source de potentiel et le potentiel de référence commun;

b) ledit moyen de commutation (50) est disposé pour connecter les bornes des moyens de stockage d'énergie (26, 36) qui sont connectées à la source de potentiel;

c) la charge (54) est connectée entre les bornes des moyens de stockage d'énergie (26, 36) qui sont connectés au potentiel de référence; et

d) la seconde borne (40, 64) de la charge (54) est en outre connectée au potentiel de référence commun au moyen d'une résistance (42) ou d'une diode dont la polarité est opposée à la polarité du moyen de stockage d'énergie.

2. Circuit de commande de tension comprenant un premier moyen de stockage d'énergie (78) et un second moyen de stockage d'énergie (84), ces deux moyens de stockage étant adaptés à stocker de l'énergie électrique fournie à partir d'une source de potentiel par l'intermédiaire d'un moyen de limitation de courant, fournissant ainsi une première tension d'une première amplitude et une seconde tension d'une seconde amplitude et comprenant en outre un moyen de commutation (94, 98) pour connecter électriquement les premier et second moyens de stockage d'énergie en série, de façon à fournir une tension de sortie liée à la somme des première et seconde amplitude sur une charge (100), caractérisé en ce que:

a) la source de potentiel fournit un premier potentiel (HVAC, 80; +HVDC) d'une première polarité et un second potentiel (HVAC, 86; −KVDC) d'une polarité opposée, les deux potentiels étant associés à un potentiel de référence commun pour charger séparément les premier et second moyens de stockage d'énergie (78, 84); et

b) une borne du moyen de connexion (94), ainsi qu'une borne de la charge (100) est connectée au potentiel de référence commun, et en ce que les autres bornes du moyen de connexion (94) et de la charge (100) sont connectées par la connexion en série des deux moyens de stockage d'énergie (78, 84), un noeud de circuit commun (92) des deux moyens de stockage d'énergie étant connecté au potentiel de référence commun au moyen d'une résistance (102).

3. Circuit de commande de tension selon l'une des revendications 1 ou 2, caractérisé en ce que la source de potentiel est une source de potentiel alternatif (HVAC) comprenant des moyens de redressement (24, 80; 34, 86) connectés en série avec les moyens de stockage d'énergie (26, 78; 36, 84).

4. Circuit de commande de tension selon l'une des revendications 1 ou 2, caractérisé en ce que la source de potentiel comprend deux sources de tension continue (+KVDC, −KVDC).

5. Circuit de commande de tension selon l'une des revendications 1 à 4, caractérisé en ce que le moyen de commutation est un éclateur (50; 94).

6. Circuit de commande de tension selon la revendication 3, caractérisé en ce que les moyens de redressement sont des diodes (24, 34; 80, 86).

7. Circuit de commande de tension selon l'une des revendications 1 à 4, caractérisé en ce que les moyens de stockage d'énergie sont des condensateurs (26, 36; 78, 84) ayant la même valeur de capacité.

FIG.1 PRIOR ART

FIG.2

FIG.3

FIG.4

FIG.5